# FASCICULE DE BREVET EUROPEEN

(11) **EP 3 563 378 B1**
(45) Date de publication et mention de la délivrance du brevet: **13.01.2021**
(21) Numéro de dépôt: 17821649.5
(22) Date de dépôt: 22.12.2017
(51) Int. Cl.: G11C 13/00, H01L 45/00, H01L 27/24

(54) **PROCÉDÉ D'UTILISATION DE COMPOSANTS ÉLECTROCHIMIQUES POUR LE STOCKAGE D'ÉNERGIE ET D'INFORMATION ET CIRCUIT ÉLECTRONIQUE ASSOCIÉ**
VERWENDUNG ELEKTROCHEMISCHER BAUELEMENTEN ZUR SPEICHERUNG VON ELEKTRISCHER ENERGIE UNF INFORMATION UND ZUGEHÖRIGE ELEKTRONISCHE SCHALTUNG
USE OF ELECTROCHEMICAL COMPONENTS FOR ENERGY STORAGE AND INFORMATION STORAGE AND ASSOCIATED ELECTRONIC CIRCUIT

(30) Priorité: 02.01.2017 FR 1750005
(43) Date de publication de la demande: 06.11.2019
(73) Titulaire: Commissariat à l'Énergie Atomique et aux Énergies Alternatives, 75015 Paris (FR)
(72) Inventeur: LEE, Daeseok, 38100 Grenoble (FR); MOLAS, Gabriel, 38000 Grenoble (FR); OUKASSI, Sami, 38120 Saint-Égrève (FR)
(74) Mandataire: Cabinet Camus Lebkiri
(86) Numéro de dépôt international: PCT/EP2017/084335
(87) Numéro de publication internationale: WO 2018/122156

(56) Documents cités:
- US-A1- 2016 071 565
- MICHAEL N KOZICKI ET AL: "Conductive bridging random access memory-materials, devices and applications", SEMICONDUCTOR SCIENCE AND TECHNOLOGY, IOP PUBLISHING LTD, GB, vol. 31, no. 11, 5 octobre 2016 (2016-10-05), page 113001, XP020309909, ISSN: 0268-1242, DOI: 10.1088/0268-1242/31/11/113001 [extrait le 2016-10-05]
- I. VALOV ET AL: "Nanobatteries in redox-based resistive switches require extension of memristor theory", NATURE COMMUNICATIONS, vol. 4, 23 avril 2013 (2013-04-23), page 1771, XP055403546, DOI: 10.1038/ncomms2784 cité dans la demande
- LEE DAESEOK ET AL: "Memory and Energy Storage Dual Operation in Chalcogenide-Based CBRAM", IEEE JOURNAL OF THE ELECTRON DEVICES SOCIETY, IEEE, USA, vol. 5, no. 4, 1 juillet 2017 (2017-07-01) , pages 283-287, XP011653517, DOI: 10.1109/JEDS.2017.2693220

## Description

### Domaine Technique

La présente invention se rapporte à un procédé d'utilisation de composants électrochimiques pour le stockage d'énergie et d'information et au circuit électronique associé. Elle trouve des applications, en particulier, dans le domaine de l'électronique intégrée.

### Art Antérieur

L'utilisation de composants électrochimiques aux dimensions micro ou nanométriques pour l'intégration à des circuits électroniques est largement connue de l'homme du métier. Les mémoires vives résistives en sont une illustration et, notamment, les mémoires vives résistives de type OxRRAM (de l'anglais Oxyde Resistive Random Access Memory) et CBRAM (de l'anglais Conductive Bridging Random Access Memory). Une CBRAM ainsi qu'un procédé tel qu'énoncé dans le préambule de la revendication 1 sont notamment présentés par "Conductive bridging random access memory-materials, devices and applications", SEMICONDUCTOR SCIENCE AND TECHNOLOGY, ISSN 0268-1242.

Ces deux types de mémoires vives résistives reposent sur un arrangement comprenant une première électrode, une seconde électrode et une zone active située entre les deux électrodes. C'est le fait que cette zone active puisse passer d'un état isolant à un état conducteur par application d'une tension externe qui permet de réaliser la fonction de mémoire dans les deux cas.

En effet, l'information, sous forme de donnée binaire, est stockée dans ces composants à travers leur état qui peut être soit fortement résistif (en anglais « High Résistance State » HRS) qui correspond à un état dit « OFF » soit faiblement résistif (en anglais « Low Résistance State » LRS) qui correspond à un état dit « ON ».

La bascule entre les deux états de ce type de composant mémoire, qu'il s'agisse d'OxRRAM ou de CBRAM, intervient donc sous l'effet de l'application d'une tension déterminée. Cette tension provoque la création dans la zone active d'un chemin conducteur, dont le type et la forme varie suivant les modes de réalisation, et qui induit cette bascule.

La différence entre les deux types de mémoire réside dans l'utilisation, pour les OxRRAM, d'une zone active avec un matériau à base d'oxyde, tel qu'un oxyde binaire de transition, dans lequel un ou des chemin(s) conducteur(s) est/sont formé(s) par des lacunes d'oxygènes, alors que dans le cas des CBRAM, la zone active intègre un matériau à conduction ionique et le ou les chemin(s) conducteur(s) est/sont formés à partir d'ions provenant d'une électrode métallique soluble et/ou dispersés dans la zone active.

Plusieurs solutions de l'art antérieur s'inscrivent dans une optique d'élargissement des possibilités offertes par ce type de composants.

L'article de Nature Communications, Valov et al, 2784, 2013 décrit, par exemple, l'exploitation des propriétés physiques d'un composant de type mémoire résistive, dont le fonctionnement est basé sur l'occurrence de réactions d'oxydoréductions, pour obtenir une force électromotrice intrinsèque (en anglais « electromotive force ») ou emf provenant du mouvement des ions.

Les auteurs font donc la démonstration expérimentale et théorique de l'existence, dans ce type de composant (ici une mémoire résistive), d'une emf résultant de la création de différents gradients de potentiels chimiques entre les deux électrodes du composant lorsqu'aucun chemin conducteur de type filament n'est créé entre celles-ci.

Cette force électromotrice est considérée comme une tension générée par le composant et peut être obtenue par dissolution d'une électrode active dans la zone active (ici un électrolyte) par un processus électrochimique, c'est ce que les auteurs considèrent comme étant la démonstration d'un effet « nano-batterie ».

Toutefois, les auteurs concluent que la force électromotrice observée (et l'effet nano-batterie associé) ne fait que suggérer l'existence d'un effet nano-batterie et proposent l'extension des modèles théoriques à même de décrire les phénomènes physiques régissant le fonctionnement des mémoires résistives en intégrant cet effet.

L'article ne divulgue donc pas toutes les caractéristiques nécessaires au fonctionnement d'un composant pour le stockage d'énergie et ne décrit pas la faisabilité concrète d'une telle application. En particulier, la force électromotrice n'est mesurée que dans l'état oxydé qui correspondrait uniquement à l'état déchargé d'une batterie. De plus, aucune démonstration de la répétabilité ou de la réversibilité des phénomènes décrits au sein du composant n'est faite.

Le brevet US9001558B2 décrit quant à lui une matrice de mémoires résistives de type CBRAM et divulgue un procédé non destructif de lecture de l'état (0 ou 1) des mémoires de cette matrice reposant sur l'utilisation de la force électromotrice. La force électromotrice est ainsi exploitée dans un composant originellement conçu pour le stockage d'information. L'invention ne concerne qu'un procédé de lecture d'états de mémoires et évoque nullement une possible exploitation de cette force pour le stockage d'énergie.

A l'inverse, le brevet US7785737B2 divulgue le fait d'utiliser des batteries aux dimensions nanométriques, dites nano-batteries, pour stocker de l'information. Le principe décrit dans ce document repose sur le fait que ces nano-batteries, présentant une structure de type électrode/électrolyte/électrode, produisent une tension donnée par application d'un courant externe. Cette tension étant liée au matériau utilisé, différentes nano-batteries, formées par des structures différentes, délivrent donc des tensions différentes. Ces différentes valeurs de tension, assimilées à des états (par exemple 0 ou 1), peuvent servir à stocker de l'information.

Chaque état logique correspond à un état de charge d'une nano-batterie. Un composant formé d'un arrangement de matériaux spécifique peut donc stocker deux états différents. Cependant, la cinétique de changement d'état associée à ce type de dispositifs s'avère très lente et limite, de ce fait, les applications réalisables avec de tels composants.

Le document US2016/071565 propose un procédé d'utilisation de composants à trois couches pouvant réaliser une fonction de mémoire et de batterie, les états de chargement de la batterie -"fully charged", "fully discharged"-formant les états mémoire.Le document "Memristive and neuromorphic behavior in a LixCoO2 nanobattery", V.H. Mai et al, Scientific Reports 5, 7761 (2015), décrit aussi l'existence d'une force électromotrice pour un composant MIM, la force électromotrice est mesurée dans l'état ON qui est décrit comme filamentaire.

### Résumé de l'Invention

L'invention proposée offre une solution au problème technique de l'utilisation d'un composant électrochimique à deux fins différentes, de manière peu coûteuse et faisant appel à une fabrication simple. Elle permet en effet d'utiliser des composants électrochimiques, composés des mêmes matériaux et suivant un même agencement, pour réaliser le stockage d'énergie ou pour réaliser le stockage d'information.

A cette fin, un aspect de l'invention se rapporte à un procédé d'utilisation d'une pluralité de composants électrochimiques élémentaires intégrés à un circuit électronique, lesdits composants comprenant trois couches, formés des trois mêmes matériaux et ayant la même épaisseur, lesdites trois couches composant respectivement une première électrode, une seconde électrode, et une zone active entre lesdites première et seconde électrodes, lesdits composants pouvant être utilisés pour le stockage d'information ou pour le stockage d'énergie,
ledit procédé comprenant :
- une étape dans laquelle au moins un composant est utilisé pour le stockage d'information via la formation et la dissolution d'un chemin conducteur entre lesdites première et seconde électrodes pour faire basculer ledit composant d'un état faiblement résistif à un état fortement résistif, et réciproquement, en appliquant respectivement une première et une seconde tension externe audit composant ;
- une étape dans laquelle au moins un autre composant est utilisé pour le stockage d'énergie via l'injection d'ions issus de la première électrode et sans former de chemin conducteur, dans la zone active pour faire basculer le composant d'un premier état fortement résistif, associé à une première valeur de force électromotrice, à un second état fortement résistif, associé à une seconde valeur de force électromotrice, et réciproquement, en appliquant respectivement une troisième tension externe différente de la première tension externe et/ou un premier courant et une quatrième tension externe audit composant et/ou un second courant.

Sur la base du procédé selon l'invention, il est possible pour une pluralité de composants électrochimiques élémentaires identiques intégrés à un circuit électronique d'utiliser au moins un composant pour le stockage d'information et au moins un composant pour le stockage d'énergie. Dit autrement, il est possible, via ce procédé, d'utiliser un même composant sans changer sa structure comme une mémoire ou comme une batterie.

Le procédé réduit donc les étapes de fabrication impliquées en nécessitant, par exemple, l'emploi de moins de matériaux et en rendant l'intégration plus facile sur un même circuit. En effet, puisque des mêmes composants intégrés à un unique circuit peuvent réaliser une fonction de mémoire ou de batterie, il est possible de fabriquer des produits plus compacts, plus économes en énergie et donc plus économiques.

Outre les caractéristiques évoquées précédemment, le procédé selon l'invention peut présenter une ou plusieurs des caractéristiques complémentaires suivantes, considérées individuellement ou selon toutes les combinaisons techniquement réalisables :
- le ou les composants électrochimiques élémentaires intégrés au circuit électronique et utilisés pour stocker de l'énergie sont utilisés pour alimenter en énergie et commander au moins une partie des autres composants électrochimiques utilisés pour stocker de l'information ;
- au moins un composant électrochimique élémentaire est conservé dans un état initial ou fortement résistif permettant à un utilisateur dudit circuit de choisir d'utiliser ce ou ces composants pour le stockage d'information ou pour le stockage d'énergie ;
- le ou les composants électrochimiques élémentaires intégrés au circuit électronique et utilisés pour stocker de l'énergie sont utilisés pour alimenter en énergie un ou plusieurs autres circuits intégrés sur une même puce.

Un autre aspect de l'invention porte sur un circuit électronique intégrant une pluralité de composants électrochimiques lesdits composants comprenant trois couches, formés des trois mêmes matériaux et ayant la même épaisseur, lesdites trois couches composant respectivement une première électrode, une seconde électrode, et une zone active entre lesdites première et seconde électrodes, lesdits composants pouvant être utilisés pour le stockage d'information ou pour le stockage d'énergie, ledit circuit électronique comportant des moyens pour la mise en œuvre du procédé de l'invention.

Outre les caractéristiques évoquées précédemment, le circuit selon l'invention peut présenter une ou plusieurs des caractéristiques complémentaires suivantes, considérées individuellement ou selon toutes les combinaisons techniquement réalisables :
- les composants peuvent être formés par un agencement de couches de matériaux de type mémoire « CBRAM » comportant une première électrode métallique soluble, une seconde électrode métallique et un électrolyte entre lesdites première et seconde électrodes ;
- les composants peuvent être formés par un agencement de couches de matériaux de type mémoire « OxRRAM » comportant une première électrode, une seconde électrode et un matériau à base d'oxyde entre lesdites première et seconde électrodes ;
- les zones actives situées entre lesdites première et seconde électrodes des composants peuvent être composées de matériaux choisis parmi les matériaux suivants : matériau sulfuré ou oxyde de silicium ou oxyde de métal de transition ;
- la surface des composants utilisés pour le stockage d'énergie peut être adaptée pour alimenter en énergie et opérer des composants utilisés pour le stockage d'information ayant une surface et un nombre de cycles de fonctionnement prédéterminés.

### Brève Description des Dessins

D'autres caractéristiques et avantages de l'invention apparaîtront à la lecture de la description qui suit de modes de réalisation non limitatifs, en référence aux dessins annexés dans lesquels :
- la figure 1 montre un mode de mise en œuvre du procédé de l'invention ;
- la figure 2 montre un mode de réalisation du circuit selon l'invention ;
- la figure 3 est une représentation schématique de l'arrangement formant un composant de type mémoire résistive ;
- la figure 4 montre une courbe illustrant le basculement entre les deux niveaux de résistance lors du fonctionnement d'une mémoire de type CBRAM;
- la figure 5 montre un diagramme schématique de l'évolution des valeurs d'emf correspondant aux deux états d'un composant électrochimique de type mémoire CBRAM ;
- la figure 6 montre une courbe de dépendance des caractéristiques de durée et de tension d'impulsions permettant la bascule entre les états d'un composant de type mémoire CBRAM ;
- les figures 7A et 7B montrent l'énergie disponible (extraites à partir des courbes de déchargement) pour un composant utilisé pour le stockage d'énergie en fonction de différentes conditions utilisées pour son chargement ;
- la figure 8 montre l'évolution dans le temps de la valeur d'emf pour les deux états nécessaires au fonctionnement d'un composant électrochimique pour le stockage d'énergie ;
- la figure 9 montre la quantité totale de charge disponible sur un circuit intégrant un nombre de composant d'une surface de 1 µm² ;
- la figure 10 montre le nombre attendu de composants intégrés à un unique circuit devant être opérés pour réaliser le stockage d'énergie pour pouvoir opérer un nombre donné de composants dédiés au stockage d'information ;
- les figures 11A et 11B montrent les corrélations entre un nombre de composant utilisés pour le stockage d'énergie, un nombre de composant utilisés pour le stockage d'information et un nombre de cycle de bascule entre deux états de résistance ;
- la figure 12 est une illustration simplifiée des connections pouvant être établies pour permettre d'opérer une paire de composants réalisant respectivement les fonctions de stockage d'énergie et de stockage d'information ;
- la figure 13 montre un autre mode de réalisation du circuit selon l'invention ;
- la figure 14 montre les zones de fonctionnement en courant et en tension pour un unique composant opéré soit en tant que mémoire soit en tant que batterie.
- la figure 15 montre un diagramme de block illustrant les différentes étapes/actions permettant les utilisations d'un même composant comme mémoire ou comme batterie.

### Description détaillée de modes de réalisation

La présente invention ne se limite pas aux formes de réalisation présentées ici. D'autres variantes et modes de réalisation peuvent être déduits et mis en œuvre par l'homme du métier à la lecture de la présente description et des dessins annexés.

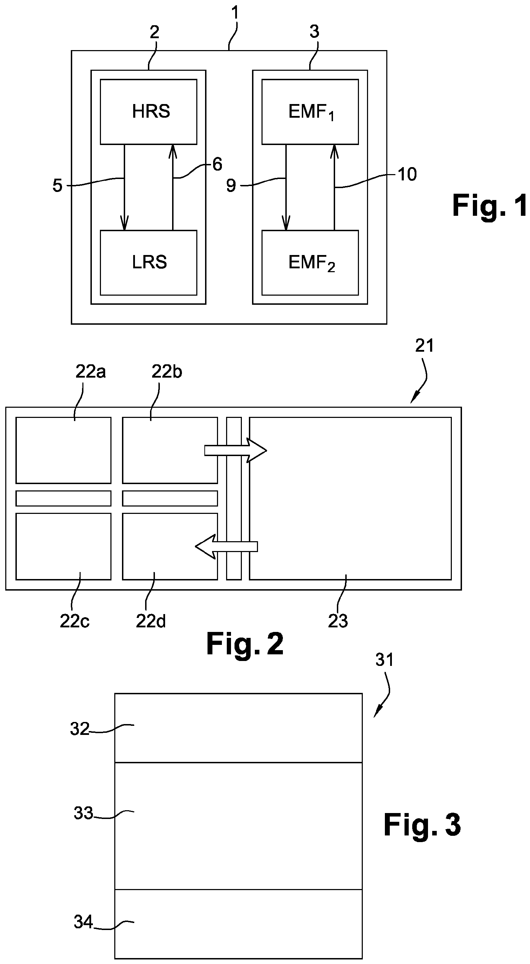

La Figure 1 montre un diagramme décrivant un mode de mise en œuvre du procédé 1 de l'invention qui comprend deux étapes : une étape 2 de stockage d'information et une étape 3 de stockage d'énergie. Plus précisément, l'étape 2 réalise la fonction de stockage d'information pour au moins un composant électrochimique élémentaire et l'étape 3 réalise la fonction de stockage d'énergie pour au moins un autre composant électrochimique élémentaire. Ces composants électrochimiques élémentaires ont la même structure, c'est-à-dire le même arrangement de couches (i.e. matériaux identiques et épaisseurs identiques, seule la surface pouvant le cas échéant varier), et sont intégrés à un circuit électrique unique tel que celui décrit dans la Figure 2.

La Figure 2 montre un mode de réalisation du circuit selon l'invention dans lequel un ensemble de composants électrochimiques élémentaires, formés du même arrangement et fabriqués suivant un même procédé de fabrication, sont intégrés à un unique circuit intégré 21 et sont utilisés pour réaliser, pour au moins un composant, la fonction de stockage d'information, et pour au moins un autre composant, la fonction de stockage d'énergie. De plus, le ou les composants utilisés pour stocker l'information sont, dans ce mode de mise en œuvre, alimentés en énergie/opérés par le ou les composants utilisés pour stocker de l'énergie. L'exemple de la Figure 2 décrit donc schématiquement 4 composants mémoires 22a, 22b, 22c et 22d opérés par un composant batterie 23 (dont la surface est supérieure à celle des composants mémoires). Chaque composant de ce circuit 22a, 22b, 22c, 22d et 23 est formé du même arrangement de matériaux tel que celui décrit en Figure 3.

La Figure 3 montre une représentation schématique de la structure (formée d'un arrangement de matériaux différents) d'un composant électrochimique élémentaire 31 conforme à ceux de l'invention. Une zone active 33, formée d'un matériau résistif, qui peut par exemple être un électrolyte ou un isolant, est située entre une première électrode 32 et une seconde électrode 34.

En référence à la Figure 1, l'étape 2 du procédé 1 comprend l'action de basculer d'un état fortement résistif HRS vers un état faiblement résistif LRS et réciproquement par la formation 5 et la dissolution 6 d'un chemin conducteur dans la zone active 33 d'un composant en appliquant respectivement une première et une deuxième tension. L'étape 3 comprend l'action de basculer d'un état ayant une valeur donnée de force électromotrice EMF₁ à un état ayant une autre valeur de force électromotrice EMF₂ et réciproquement, respectivement par une réaction d'oxydation 9 provoquant l'injection d'ions issus de la première électrode 32 sans former de chemin conducteur dans la zone active 33 obtenue en appliquant une troisième tension et/ou un premier courant et par une réaction de réduction 10 obtenue en appliquant une quatrième tension et/ou un deuxième courant au composant.

L'invention repose donc sur l'utilisation de composants électrochimiques présentant un arrangement en couches de matériaux différents permettant, entre autres, de les faire fonctionner comme des mémoires résistives, et, en particulier, comme des mémoires de type CBRAM ou comme des mémoires de type OxRRAM. Les figures suivantes décrivent certaines caractéristiques physiques liées au fonctionnement de ces composants qui sont exploitées par le procédé de l'invention pour pouvoir utiliser les composants pour le stockage d'énergie et pour le stockage d'information.

Dans un composant mémoire de type CBRAM, la première électrode peut être désignée en anglais par « working electrode » (que l'on appellera électrode W par la suite) signifiant qu'il s'agit de l'électrode dans laquelle la réaction d'intérêt (pour le fonctionnement de la mémoire) se produit par opposition à la seconde électrode désignée en anglais par « counter electrode » ou « auxiliary electrode » (que l'on appellera électrode C par la suite) signifiant qu'il s'agit de l'électrode utilisée pour appliquer un courant ou une tension entre les deux électrodes.

Comme décrit précédemment, le fonctionnement des mémoires résistives repose sur leur capacité à basculer de manière réversible entre deux états de résistances différentes par l'application d'une tension externe (aussi appelée bias). Ainsi par l'application d'une première tension dite de SET la mémoire bascule d'un état fortement résistif HRS à un état faiblement résistif LRS et par l'application d'une seconde tension dite de RESET la mémoire effectue la bascule inverse.

Il est à noter que, outre les deux états de résistance HRS et LRS que peut présenter le composant, l'état initial, existant préalablement à ces deux états, est un état dans lequel la zone active 33 présente une résistance généralement supérieure à la valeur de résistance associée à l'état HRS. Ceci implique qu'une tension externe est préalablement appliquée au composant pour pouvoir générer l'état LRS pour la première fois avant de pouvoir basculer de manière réversible de l'état LRS à l'état HRS.

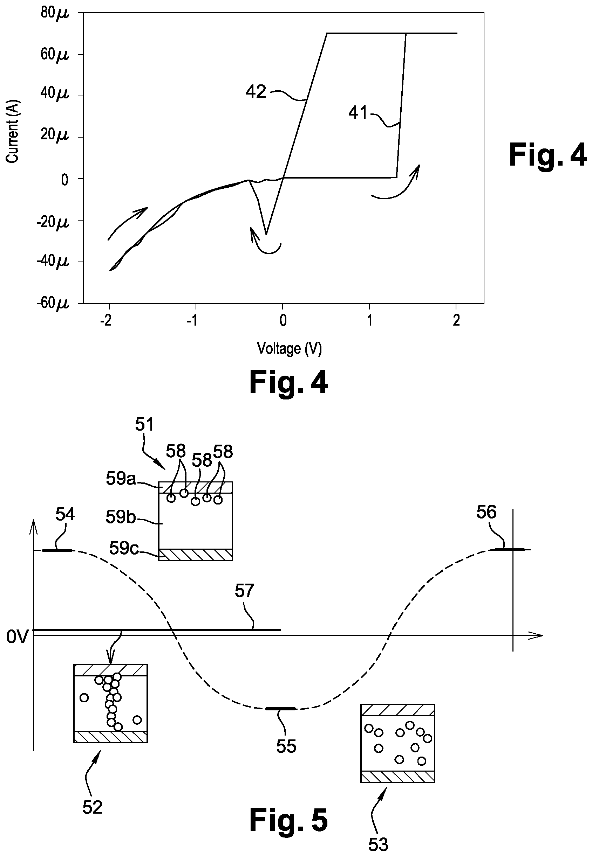

La Figure 4 est une courbe courant tension qui se rapporte au fonctionnement d'une mémoire de type CBRAM et en particulier à un cas dans lequel la zone active est formée d'une couche de GeS₂. La courbe fait apparaitre le déroulement typique du basculement entre les deux niveaux de résistance à l'origine du fonctionnement d'un tel composant notamment à travers une augmentation abrupte du courant 41 liée à la formation d'un filament conducteur puis d'une chute de ce même courant 42 par dissolution de ce filament. Dans ces mémoires, le chemin conducteur (ici un filament) peut être formé entre les deux électrodes par nucléation d'ions initialement apportés par dopage dans la zone active ou par diffusions d'ions métalliques provenant de l'électrode soluble dans la zone active durant un processus appelé FORMING. C'est ce chemin dont la répartition peut être modifiée ou qui peut être dissous par l'application d'une tension externe spécifique entraînant une modification plus ou moins importante de la conduction électrique entre les deux électrodes. Ces dernières étapes, associées au SET et au RESET de la mémoire, permettent la bascule entre les états HRS et LRS.

Au-delà des réactions électrochimiques à l'origine de cette bascule entre états fortement et faiblement résistifs d'autres réactions électrochimiques peuvent se produire avant le processus de FORMING, c'est-à-dire dans l'état initial d'une mémoire, mais aussi dans l'état fortement résistif HRS. L'article de Nature Communications précédemment mentionné fait notamment état, dans une mémoire du type CBRAM, de l'observation d'autres réactions électrochimiques à travers une mesure de voltampérométrie cyclique.

En particulier, dans un composant électrochimique dont le fonctionnement est basé sur l'occurrence de réactions d'oxydo-réductions et dont l'agencement est de type Ag/SiO₂/Pt il est possible d'oxyder l'électrode d'argent (électrode W) en appliquant une tension positive alors qu'une réaction de réduction sur la même électrode se produit en appliquant une tension négative. L'oxydation peut entraîner la migration des ions argent dans la couche de SiO₂ ce qui induit une force électromotrice (emf). Cette emf peut être considérée comme une énergie délivrée par un générateur qui résulte d'un gradient de concentration en ions métalliques (ici en ions Ag) entre les deux électrodes. L'emf de l'état oxydé correspond à l'état déchargé d'une batterie.

Le procédé de l'invention présenté ici implique, au-delà de l'exploitation de l'emf de l'état oxydé, l'exploitation de l'emf de l'état réduit. Réaliser une bascule réversible entre les valeurs d'emf correspondant aux états oxydé et réduit permet d'utiliser la différence d'emf comme source d'énergie. Le passage d'une première valeur d'emf à une seconde valeur d'emf se traduit par un changement d'état de charge au niveau de la structure. Cet état de charge est modifié par la migration d'une certaine quantité d'ions d'une électrode vers l'autre à travers la couche intermédiaire et finit par un changement d'état d'oxydation de l'ion en question. Ce mécanisme d'oxydo-réduction est accompagné par un échange électronique, depuis ou vers le composant (respectivement étape de décharge ou de charge) et permet ainsi de stocker de l'énergie au sein de la structure (dite nano-batterie) ou de la délivrer, par exemple, à un circuit extérieur. Cette énergie prend la forme d'un couple courant/tension. Plus particulièrement, le composant se comporte comme une source de tension qui décharge un certain courant, c'est-à-dire qu'il délivre une quantité de charge qui correspond à un courant donné pendant une certaine durée (le temps de décharge). Le composant conçu selon un arrangement propre à la réalisation d'une fonction de stockage d'information réalise alors une fonction de stockage d'énergie.

Les Figures 5 à 11 montrent certaines caractéristiques physiques de composants électrochimiques, conçus à l'origine comme des mémoires, qui sont exploitées par le procédé de l'invention pour utiliser ces mêmes composants comme des batteries.

La Figure 5 montre un diagramme schématique illustrant les changements de la valeur d'emf attendues correspondant à deux états distincts d'un composant électrochimique de type mémoire CBRAM exploité pour le stockage d'énergie. L'emf résultant d'un gradient de concentration en ions métalliques entre les deux électrodes, il est possible d'obtenir une valeur d'emf élevée (qu'elle soit positive ou négative) dans l'état réduit de l'électrode W et réciproquement d'obtenir une valeur d'emf élevée mais de signe opposé dans l'état oxydé de cette même électrode.

L'état réduit 51 représenté dans la figure 5 fait apparaître l'électrode W métallique 59a et l'électrode C 59c. La zone active de la mémoire résistive 59b contient des ions issus de l'électrode W représentés schématiquement par des cercles 58. La valeur d'emf associée à cet état est appelé emf haut 54 et correspond à l'état chargé d'une batterie.

Réciproquement, l'état oxydé 53 engendre la diffusion des ions métalliques issus de l'électrode W dans la zone active. La valeur d'emf associée à cet état est appelée emf bas 55 et correspond à l'état déchargé d'une batterie. La courbe en pointillée illustre le fait que ce basculement est cyclique et réversible. Ainsi l'état correspondant à l'emf haut 56 est identique à celui correspondant à l'emf haut 54.

La ligne 57 illustre le fait que la création d'un chemin conducteur 52 dans la zone active génère un court-circuit et par conséquent annihile l'emf. Le fait d'exploiter la bascule entre deux valeurs d'emf pour obtenir la capacité à stocker de l'énergie nécessite donc d'éviter la création d'un tel chemin conducteur et implique l'utilisation sélective du composant comme stockage d'énergie ou comme stockage d'information.

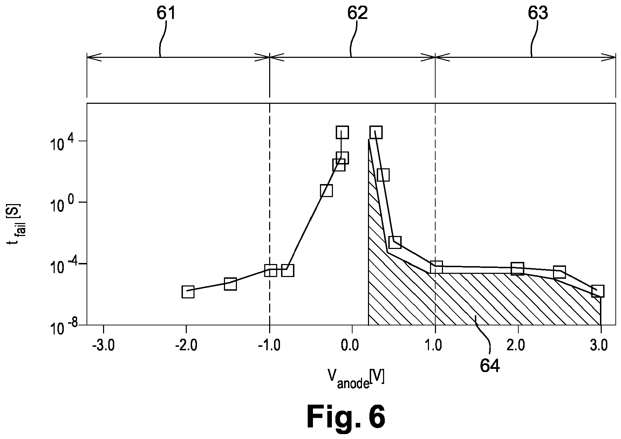

La Figure 6 montre une courbe de dépendance des caractéristiques de durée et de tension, respectivement en secondes et en volts, d'impulsions permettant la bascule entre les états d'un composant mémoire de type mémoire résistive CBRAM. La zone 61 couvre les caractéristiques d'impulsion permettant d'effectuer l'opération de RESET de la mémoire alors que la zone 63 couvre les caractéristiques d'impulsions permettant d'effectuer l'opération de SET de la mémoire. La zone intermédiaire 62 correspond quant à elle à une zone, dite zone « Read Disturb », où les caractéristiques d'impulsions sont impropres à une bonne utilisation de ce type de composants mémoires.

La tension externe (ou bias) appliquée au composant pour opérer la fonction mémoire est donc, dans le cas décrit pour ce mode de réalisation, une tension négative pour l'opération de RESET et une tension positive pour l'opération de SET.

Comme décrit précédemment, le fait de pouvoir opérer le composant en tant que batterie, c'est-à-dire pour le stockage d'énergie repose sur l'occurrence de réactions d'oxydo-réductions. L'oxydation doit être réalisée sans provoquer la création d'un chemin conducteur (un filament par exemple) dans la zone active située entre les deux électrodes du composant. Ceci implique d'utiliser des impulsions de contrôles dont les caractéristiques de durée et de tension sont spécifiques.

La zone 64 sur la Figure 6 couvre donc toutes les caractéristiques d'impulsions utilisables pour obtenir une réaction d'oxydation de l'électrode W conduisant à l'injection d'ions issus de cette électrode dans la zone active sans entraîner la création d'un chemin conducteur. Ceci permet de basculer à l'état emf bas (associé à l'état oxydé).

La réaction de réduction permettant la bascule vers l'état emf haut (associé à l'état réduit) n'impose pas de restrictions sur les caractéristiques de durée et de tension de l'impulsion de contrôle. Dans le cas du mode de réalisation illustré par la figure 6, il doit uniquement s'agir d'une tension négative.

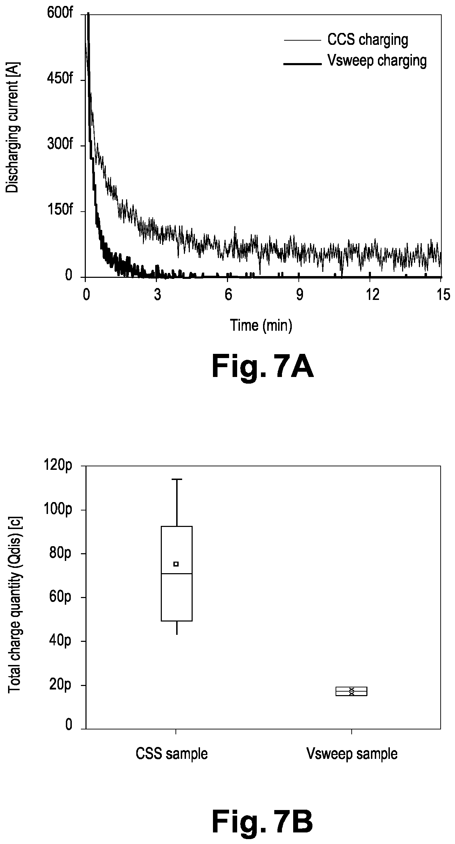

Les Figures 7A et 7B montrent l'énergie disponible pour un composant utilisé pour le stockage d'énergie en fonction de différentes conditions utilisées pour son chargement. La Figure 7A montre la décharge du courant après l'occurrence du processus de réduction dans les cas où les conditions de chargement sont celles d'un stress en tension, en noir, ou d'un stress à courant constant (en anglais Constant Current Stress CCS), en rouge. La Figure 7B montre la quantité de charge totale disponible (Qdis) pour les deux conditions de chargement décrite dans la Figure 7A.

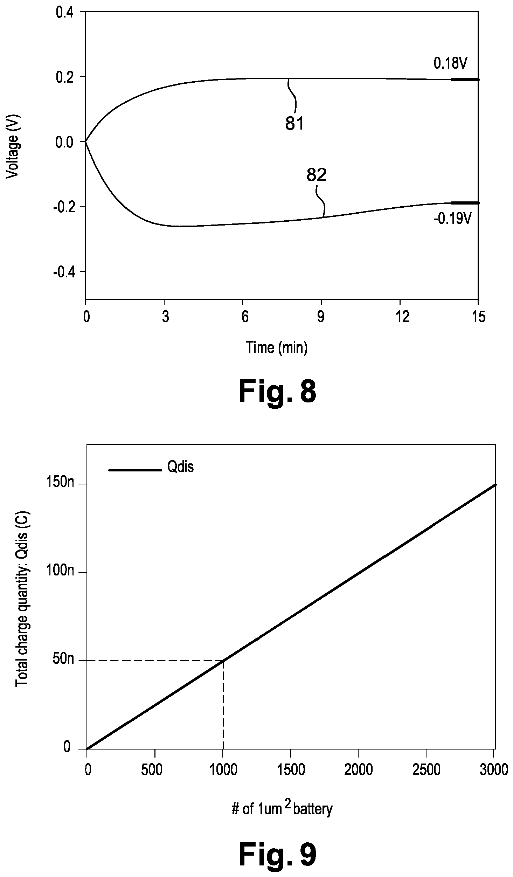

La Figure 8 montre l'évolution dans le temps de la valeur d'emf (en volt) pour les deux états nécessaires au fonctionnement du composant comme stockage d'énergie. Il s'agit d'un mode de réalisation basé sur un arrangement de matériaux de type CuTe2Ge/Ta₂O₅/W pour une mémoire de type CBRAM. La courbe 81 décrit l'évolution dans le temps de la valeur d'emf correspondante à l'état oxydé jusqu'à converger vers un état sable, l'état emf haut défini plus tôt, ayant une valeur d'emf donnée, ici 0.18V. La courbe 82 décrit le même comportement pour l'état réduit jusqu'à l'état emf bas ayant une valeur d'emf de -0.19V. La différence entre ces deux valeurs (0.37V) correspond à une quantité d'énergie que le composant peut stocker. Il est à noter que la surface active de ce composant est d'environ 2.2 µm².

La Figure 9 montre la quantité totale de charge disponible sur un circuit intégrant un nombre de composant d'une surface de 1 µm² dont l'arrangement est identique à celui du composant conduisant aux résultats présentés dans la Figure 8. Par exemple, pour un millier de composants élémentaires, ayant chacun une surface de 1 µm², la quantité d'énergie stockée s'élève à 50nC.

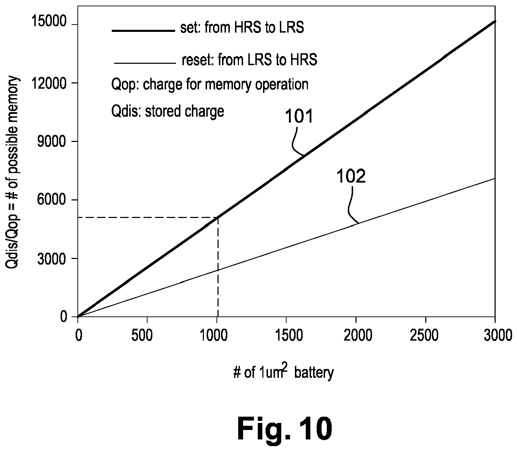

La Figure 10, reprend notamment les données issues de la Figure 9, pour montrer le nombre attendu de composants intégrés à un unique circuit devant être opérés pour réaliser une fonction de stockage d'énergie pour pouvoir opérer un nombre donné de composants, intégrés au même circuit, et dédiés au stockage de l'information. Dit autrement, combien de composants batterie doivent être utilisés pour faire fonctionner des composants mémoires du même circuit.

L'énergie requise n'étant pas la même pour les opérations de SET et de RESET d'un mémoire, c'est deux opérations sont représentées par deux courbes différentes : la courbe 101 pour l'opération de Set et la courbe 102 pour l'opération de RESET.

La courbe 101 représente donc, à partir du ratio entre la charge totale disponible (Qdis) pour un certain nombre de batteries (d'une surface connue) et la charge nécessaire pour opérer un certain nombre de mémoire, le nombre de mémoires opérable par un nombre de batteries données pour l'opération de SET. La courbe 102 représente la même information pour l'opération de RESET. Ces courbes permettent de déterminer que, dans le cas correspondant au mode de réalisation représenté par les Figures 8, 9 et 10, mille composants opérés pour stocker de l'énergie peuvent permettre de réaliser l'opération de SET pour cinq milles composants mémoires.

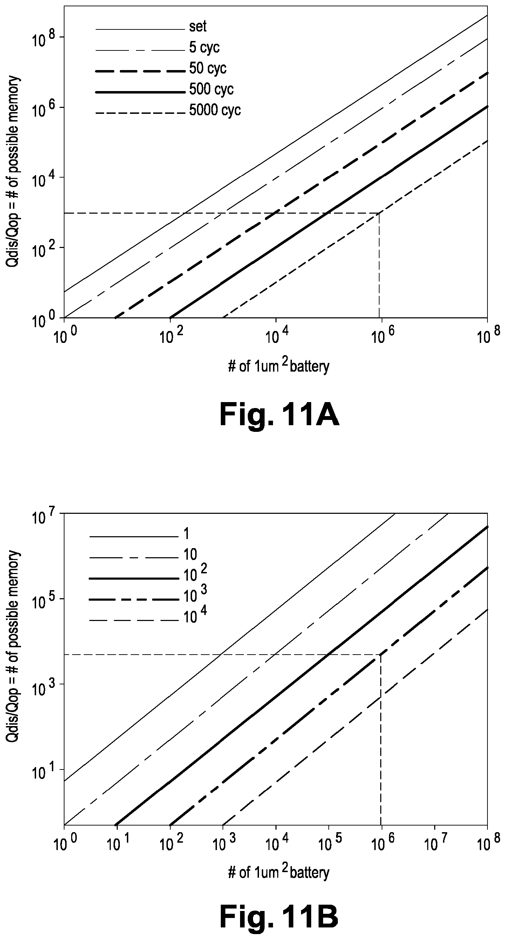

Les Figures 11A et 11B montrent, en reprenant les données issues de Figures précédentes, les corrélations entre un nombre de composant utilisés pour le stockage d'énergie, un nombre de composant utilisés pour le stockage d'information et un nombre de cycle de bascule entre les deux états de résistance correspondant au fonctionnement des composants mémoires. La figure 11A présente ces données en échelle logarithmique et la figure 11B en échelle semi-logarithmique.

Les Figures 7 à 11 montrent concrètement, pour des composants électrochimiques de type mémoire résistive, les caractéristiques de fonctionnement requises (valeurs d'emf haut et bas, charge totale disponible, cycles de fonctionnement...) pour pouvoir être utilisés pour le stockage d'énergie.

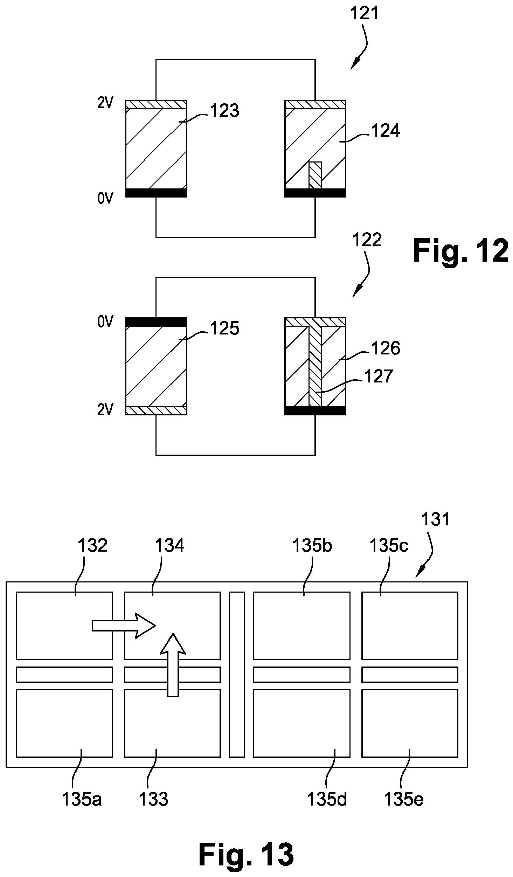

La Figure 12 est une illustration simplifiée des connections pouvant être établies pour permettre d'opérer une paire de composants formés d'un agencement identique et réalisant respectivement les fonctions de stockage d'énergie (composant batterie) et de stockage d'information (composant mémoire). En particulier, l'exemple représenté est celui d'une mémoire de type CBRAM dont le fonctionnement requiert l'application de tensions externes positives et négatives pour réaliser la bascule entre les deux états de la mémoire.

Deux types de connexions sont représentées avec une première configuration de connexion 121 destinée à la réalisation de l'opération de SET de la mémoire CBRAM et une seconde configuration de connexion 122 destinée à la réalisation de l'opération de RESET de la mémoire.

Suivant les cas, le signe de la tension appliquée à partir du composant batterie est donc inversé : une tension positive obtenue à partir du composant batterie 123 dans la configuration 121 et une tension négative obtenue à partir du composant batterie 125 dans la configuration 122.

Ces tensions externes appliquées conduisent à la bascule de l'état HRS vers l'état LRS du composant mémoire 124 et à la bascule de l'état LRS vers l'état HRS du composant mémoire 126 présentant un chemin conducteur 127 avant cette bascule.

Il est important de noter que la Figure 12 est une illustration simplifiée de connexions réalisées entre différents composants. A ce titre aucune représentation d'entités dédiées à la gestion d'alimentation (dit « power management ») ou de systèmes de commutations permettant de délivrer une tension et un courant adaptés, nécessaires au fonctionnement réel de telles configurations, n'est faite.

Finalement, la Figure 12 illustre la possibilité, à partir de composants formés du même arrangement et intégrés au même circuit d'utiliser une partie des composants comme mémoires, l'autre partie comme batteries et éventuellement ces composants batteries pour alimenter et/ou opérer les composants mémoires en leur fournissant, par exemple, un courant de programmation et une tension de commande nécessaires à de tels opérations
La Figure 13 montre un autre de réalisation du circuit selon l'invention dans lequel un ensemble de composants électrochimiques, formés du même arrangement et fabriqués suivant un même procédé de fabrication, sont intégrés à un unique circuit 131. En utilisant le procédé 1 de l'invention, une partie des composants, c'est-à-dire les composants 132 et 133 sont utilisés comme composants pour stocker l'énergie, et une partie des composants, c'est-à-dire le composant 134, est utilisée comme composant pour stocker l'information. De plus, les composants utilisés pour stocker de l'énergie fournissent cette énergie et opèrent le composant 134. Enfin un ensemble de composants intégrés au circuit, les composants 135a à 135e, est laissé dans son état initial de façon à pouvoir, par application du procédé de l'invention, déterminer l'utilisation de ces composants (soit pour le stockage d'énergie, soit pour le stockage d'information) suivant les besoins d'un utilisateur d'un tel circuit.

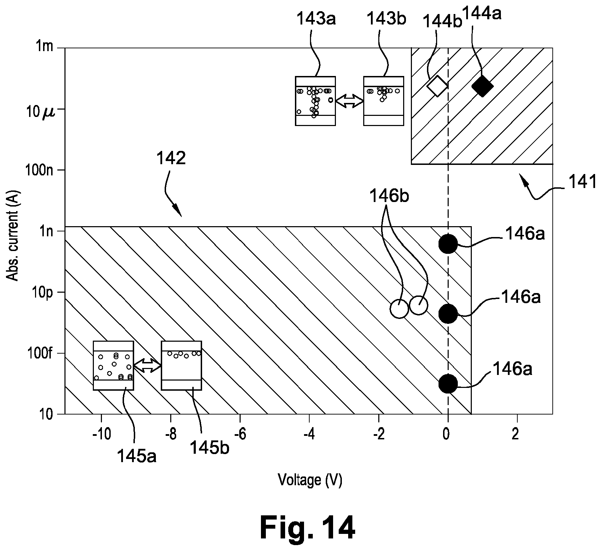

La Figure 14 montre un graphique illustrant un exemple de zones de fonctionnement en courant et en tension pour un composant unique, conforme à l'invention, opéré soit comme mémoire soit comme batterie.

La zone 141 représente les valeurs de courant et de tension appliquées au composant pour lesquelles le composant peut être opéré pour stocker de l'information, c'est-à-dire, comme une mémoire. La zone 142 représente, quant à elle, les valeurs de courant et de tension appliquées au composant pour lesquelles le composant peut être opéré pour stocker de l'énergie, c'est-à-dire, comme une batterie.

Lorsqu'il est dans le « régime mémoire », le composant bascule d'un état logique à une autre à travers la formation est la dissolution d'un filament dans la zone intermédiaire. Les encarts 143a et 143b illustrent cette bascule réciproque d'un état à l'autre (opérations de set et de reset).

Au sein de cette zone courant/tension d'opération comme mémoire, les points 144a et 144b correspondent respectivement à un composant basculant successivement d'un état fortement résistif HRS 144a à un état faiblement résistif LRS 144b qui s'alternent ensuite de manière reproductible lors du fonctionnement de la mémoire.

Lorsqu'il est dans le « régime batterie », le composant bascule d'une valeur d'emf à une autre valeur d'emf par la diffusion volumique d'ions dans la zone intermédiaire sans former de filament. Les encarts 145a et 145b illustrent cette bascule réciproque d'un état à l'autre.

Au sein de cette zone courant/tension d'opération en tant que batterie, les points 146a et 146b correspondent respectivement à deux valeurs distinctes d'emf (dont l'une est nulle) dont la bascule permet le changement d'état de charge de la batterie.

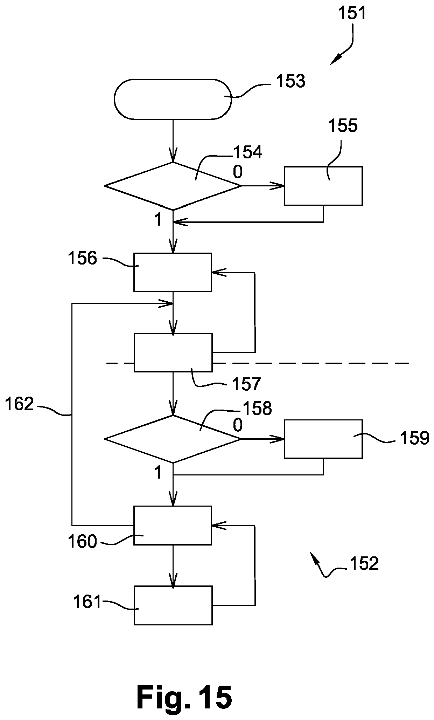

La Figure 15 montre un diagramme de block illustrant les différents régimes d'opérations d'un composant conforme à l'invention pouvant être utilisé comme une mémoire ou comme une batterie et les étapes/actions permettant ces deux utilisations.

La partie 151 correspond à l'opération du composant comme batterie et la partie 152 correspondant à l'opération du composant comme mémoire.

Le block 153 représente l'état résistif initial à partir duquel le composant pourra être opéré dans un mode ou un autre. L'étape 154 consiste à vérifier la présence d'ions chargés dans la zone active. Dans la négative, la diffusion de ces ions 155 se fait par réaction d'oxydation avant de pouvoir procéder à l'opération de la batterie. Dans l'affirmative, la batterie est opérée en alternant charge et décharge, de manière reproductible, respectivement par des étapes au cours desquelles interviennent des réactions de réduction 156 et des réactions d'oxydation 157.

La bascule vers un mode d'opération du composant comme mémoire s'opère après une étape de vérification de l'occurrence du processus de forming 158. Si le processus n'a pas eu lieu, il peut être déclenché par l'application d'une tension spécifique destinée à déclencher ce processus comme l'illustre le block 159.

Si le processus a eu lieu, le composant peut être opéré comme une mémoire par l'application d'une tension de RESET et d'une tension de SET pour déclencher respectivement les opérations de RESET 160 et de SET 161. Ces opérations sont elles aussi répétées de façon reproductible lors de l'opération du composant comme mémoire.

De plus, la flèche 162 illustre la possibilité de basculer à nouveau d'un mode d'opération comme mémoire vers un mode d'opération comme batterie.

## Revendications

1. Procédé d'utilisation (1) d'une pluralité de composants électrochimiques élémentaires (31) intégrés à un circuit électronique (21), lesdits composants comprenant trois couches, formés des trois mêmes matériaux et ayant la même épaisseur, lesdites trois couches composant respectivement une première électrode (32), une seconde électrode (34), et une zone active (33) entre lesdites première et seconde électrodes, lesdits composants pouvant être utilisés pour le stockage d'information ou pour le stockage d'énergie,
ledit procédé comprenant :
- une étape (2) dans laquelle au moins un composant est utilisé pour le stockage d'information via la formation (5) et la dissolution (6) d'un chemin conducteur entre lesdites première et seconde électrodes pour faire basculer ledit composant d'un état faiblement résistif (LRS) à un état fortement résistif (HRS), et réciproquement, en appliquant respectivement une première et une seconde tension externe audit composant ;
le procédé étant **caractérisé en ce qu'**il comprend:
- une étape (3) dans laquelle au moins un autre composant est utilisé pour le stockage d'énergie via l'injection d'ions (9) issus de la première électrode et sans former de chemin conducteur, dans la zone active pour faire basculer le composant d'un premier état fortement résistif, associé à une première valeur de force électromotrice (EMF1), à un second état fortement résistif, associé à une seconde valeur de force électromotrice (EMF2), et réciproquement, en appliquant respectivement une troisième tension externe différente de la première tension externe et/ou un premier courant et une quatrième tension externe au dit composant et/ou un second courant.

2. Procédé selon la revendication 1, dans lequel le ou les composants électrochimiques élémentaires intégrés au circuit électronique et utilisés pour stocker de l'énergie sont utilisés pour alimenter en énergie et/ou commander au moins une partie des autres composants électrochimiques utilisés pour stocker de l'information.

3. Procédé selon l'une des revendications précédentes, dans lequel au moins un composant électrochimique élémentaire est conservé dans un état initial ou fortement résistif permettant à un utilisateur dudit circuit de choisir d'utiliser ce ou ces composants pour le stockage d'information ou pour le stockage d'énergie.

4. Procédé selon l'une des revendications précédentes, dans lequel le ou les composants électrochimiques élémentaires intégrés au circuit électronique et utilisés pour stocker de l'énergie sont utilisés pour alimenter en énergie un ou plusieurs autres circuits intégrés sur une même puce.

5. Circuit électronique intégrant une pluralité de composants électrochimiques lesdits composants comprenant trois couches, formés des trois mêmes matériaux et ayant la même épaisseur, lesdites trois couches composant respectivement une première électrode, une seconde électrode, et une zone active entre lesdites première et seconde électrodes, lesdits composants pouvant être utilisés pour le stockage d'information ou pour le stockage d'énergie, ledit circuit électronique comportant des moyens pour la mise en œuvre du procédé selon l'une quelconque des revendications 1 à 4.

6. Circuit électronique selon la revendication 5, dans lequel lesdits composants sont formés par un agencement de couches de matériaux de type mémoire « CBRAM » comportant une première électrode métallique soluble, une seconde électrode métallique et un électrolyte entre lesdites première et seconde électrodes.

7. Circuit électronique selon la revendication 5, dans lequel lesdits composants sont formés par un agencement de couches de matériaux de type mémoire « OxRRAM » comportant une première électrode, une seconde électrode et un matériau à base d'oxyde entre lesdites première et seconde électrodes.

8. Circuit électronique selon l'une quelconque des revendications 5 à 7, dans lequel les zones actives situées entre lesdites première et seconde électrodes desdits composants sont composées de matériaux choisis parmi les matériaux suivants : matériau sulfuré ou oxyde de silicium ou oxyde de métal de transition.

9. Circuit électronique selon l'une quelconque des revendications 5 à 8, dans lequel la surface desdits composants utilisés pour le stockage d'énergie est adaptée pour alimenter en énergie et opérer des composants utilisés pour le stockage d'information ayant une surface et un nombre de cycles de fonctionnement prédéterminés.

## Patentansprüche

1. Nutzungsverfahren (1) einer Vielzahl von elementaren elektrochemischen Bauteilen (31), die in eine elektronische Schaltung (21) eingebaut sind, wobei die genannten Bauteile drei Schichten umfassen, die aus drei identischen Materialien gebildet sind und dieselbe Dicke aufweisen, wobei die genannten drei Schichten jeweils eine erste Elektrode (32), eine zweite Elektrode (34) und einen aktiven Bereich (33) zwischen der genannten ersten und der zweiten Elektrode bilden, wobei die genannten Bauteile zum Speichern von Informationen oder zum Speichern von Energie verwendet werden können,
wobei das genannte Verfahren umfasst:
- einen Schritt (2), bei dem wenigstens ein Bauteil zum Speichern von Informationen über die Bildung (5) und die Auflösung (6) eines Leiterpfades zwischen der genannten ersten und der zweiten Elektrode verwendet wird, um das genannte Bauteil von einem schwach ohmschen Zustand (LRS) in einen stark ohmschen Zustand (HRS) und umgekehrt umzuschalten, indem jeweils eine erste und eine zweite, zu dem genannten Bauteil externe Spannung angewendet wird;
wobei das Verfahren **dadurch gekennzeichnet ist, dass** es umfasst:
- einen Schritt (3), bei dem wenigstens ein weiterer Bauteil zum Speichern von Energie über das Einschießen von Ionen (9), die aus der ersten Elektrode stammen, und ohne Bilden eines Leiterpfades in dem aktiven Bereich verwendet wird, um das Bauteil von einem ersten stark ohmschen Zustand, der einem ersten elektromotorischen Kraftwert (EMF1) zugeordnet ist, in einen zweiten stark ohmschen Zustand, der einem zweiten elektromotorischen Kraftwert (EMF2) zugeordnet ist, und umgekehrt durch Anwenden jeweils einer dritten externen Spannung, die von der ersten externen Spannung unterschiedlich ist, und / oder einem ersten Strom und einer vierten Spannung, die zu dem genannten Bauteil extern ist, und / oder einem zweiten Strom umzuschalten.

2. Verfahren gemäß Anspruch 1, bei dem das oder die elementare(n), elektrochemische(n) Bauteil(e), das / die in die elektronische Schaltung eingebaut und zum Speichern der Energie verwendet wird / werden, zum Versorgen mit Energie und / oder Steuern wenigstens eines Teils der anderen elektrochemischen Bauteile verwendet wird / werden, um Informationen zu speichern.

3. Verfahren gemäß einem der voranstehenden Ansprüche, bei dem wenigstens ein elementares elektrochemisches Bauteil in einem ursprünglichen oder stark ohmschen Zustand beibehalten wird, der einem Nutzer der genannten Schaltung das Auswählen des Verwendens dieses Bauteils oder dieser Bauteile zum Speichern von Informationen oder zum Speichern von Energie ermöglicht.

4. Verfahren gemäß einem der voranstehenden Ansprüche, bei dem das oder die elementare(n) elektrochemische(n) Bauteil(e), das / die in die elektronische Schaltung eingebaut ist / sind und zum Speichern der Energie verwendet wird / werden, zum Versorgen von einer oder mehrerer integrierten Schaltung(en), die in einen und denselben Chip eingebaut ist / sind, mit Energie verwendet ist / sind.

5. Elektronische Schaltung, die eine Vielzahl von elektrochemischen Bauteilen enthält, wobei die genannten Bauteile drei Schichten umfassen, die aus drei identischen Materialien gebildet sind und dieselbe Dicke aufweisen, wobei die genannten drei Schichten jeweils eine erste Elektrode, eine zweite Elektrode und einen aktiven Bereich zwischen der genannten ersten und der zweiten Elektrode bilden, wobei die genannten Bauteile zum Speichern von Information oder zum Speichern von Energie verwendet sein können, wobei die genannte elektronische Schaltung Mittel zum Umsetzen des Verfahrens gemäß irgendeinem der Ansprüche 1 bis 4 umfasst.

6. Elektronische Schaltung gemäß Anspruch 5, bei der die genannten Bauteile durch eine Anordnung von Schichten aus Materialien vom Speichertyp "CBRAM" gebildet sind, umfassend eine erste lösliche Metallelektrode, eine zweite Metallelektrode und ein Elektrolyt zwischen der genannten ersten und der zweiten Elektrode.

7. Elektronische Schaltung gemäß Anspruch 5, bei der die genannten Bauteile durch eine Anordnung von Schichten aus Materialien vom Speichertyp "OxRRAM" gebildet sind und eine erste Elektrode, eine zweite Elektrode und ein Material auf Sauerstoffbasis zwischen der genannten ersten und der zweiten Elektrode umfasst.

8. Elektronische Schaltung gemäß irgendeinem der Ansprüche 5 bis 7, bei der die aktiven Bereiche, die zwischen der ersten und der genannten zweiten Elektrode der genannten Bauteile angeordnet sind, aus Materialien zusammengesetzt sind, die aus den folgenden Materialien ausgewählt sind: schwefeligen Materialien oder Siliziumoxid oder Übergangsmetall-Oxid.

9. Elektronische Schaltung gemäß irgendeinem der Ansprüche 5 bis 8, bei der die Oberfläche der genannten Bauteile, die für das Speichern von Energie verwendet sind, geeignet ist, um Bauteile, die zum Speichern von Informationen verwendet sind und die eine Oberfläche und eine Anzahl von vorbestimmten Betriebszyklen aufweisen, mit Energie zu versorgen und zu betreiben.

## Claims

1. Method for using (1) a plurality of elementary electrochemical components (31) incorporated in an electronic circuit (21), said components comprising three layers, formed from the same three materials and having the same thickness, said three layers comprising respectively a first electrode (32), a second electrode (34), and an active area (33) between said first and second electrodes, said components able to be used for information storage or for energy storage,
said method comprising:
- a step (2) in which at least one component is used for information storage via the formation (5) and the dissolution (6) of a conductive path between said first and second electrodes in order to switch said component from a low resistance state (LRS) to a high resistance state (HRS), and reciprocally, by respectively applying a first and a second external voltage to said component;
the method being **characterized in that** it comprises:
- a step (3) in which at least one other component is used for energy storage via the injection of ions (9) coming from the first electrode and without forming a conductive path, in the active area in order to switch the component from a first high resistance state, associated with a first value of electromotive force (EMF1), to a second high resistance state, associated with a second value of electromotive force (EMF2), and reciprocally, by respectively applying a third external voltage different from the first external voltage and/or a first current and a fourth external voltage to said component and/or a second current.

2. Method according to claim 1, wherein the elementary electrochemical component or components incorporated in the electronic circuit and used for energy storage are used for supplying with energy and/or controlling at least one portion of the other electrochemical components used for information storage.

3. Method according to one of the preceding claims, wherein at least one elementary electrochemical component is retained in an initial or high resistance state which allows a user of said circuit to choose to use this or these components for information storage or for energy storage.

4. Method according to one of the preceding claims, wherein the elementary electrochemical component or components incorporated in the electronic circuit and used for energy storage are used for supplying with energy one or several other integrated circuits on the same chip.

5. Electronic circuit incorporating a plurality of electrochemical components said components comprising three layers, formed from the same three materials and having the same thickness, said three layers comprising respectively a first electrode, a second electrode, and an active area between said first and second electrodes, said components able to be used for information storage or for energy storage, said electronic circuit comprising means for implementing the method according to any of claims 1 to 4.

6. Electronic circuit according to claim 5, wherein said components are formed by an arrangement of layers of materials of the "CBRAM" memory type comprising a first soluble metal electrode, a second metal electrode and an electrolyte between said first and second electrodes.

7. Electronic circuit according to claim 5, wherein said components are formed by an arrangement of layers of materials of the "OxRRAM" memory type comprising a first electrode, a second electrode and a material with an oxide base between said first and second electrodes.

8. Electronic circuit according to any of claims 5 to 7, wherein the active areas located between said first and second electrodes of said components are comprised of materials chosen from the following materials: sulphide material or silicon oxide or transition metal oxide.

9. Electronic circuit according to any of claims 5 to 8, wherein the surface of said components used for information storage is adapted to supply with energy and to operate components used for information storage that have a predetermined surface and number of operating cycles.
